# EUROPÄISCHE PATENTSCHRIFT

(11) **EP 0 730 308 B1**
(45) Veröffentlichungstag und Bekanntmachung des Hinweises auf die Patenterteilung: **29.07.1998**
(21) Anmeldenummer: 96102747.1
(22) Anmeldetag: 23.02.1996
(51) Int. Cl.: H01L 29/10, H01L 29/739, H01L 27/07

(54) **Integrierte Schaltungsanordnung mit mindestens einem IGBT**
Integrated circuit structure with at least one IGBT
Dispositif de circuit intégré avec au moins un IGBT

(30) Priorität: 01.03.1995 DE 19507169
(43) Veröffentlichungstag der Anmeldung: 04.09.1996
(73) Patentinhaber: SIEMENS AKTIENGESELLSCHAFT, 80333 München (DE)
(72) Erfinder: Oppermann, Klaus-Günter, 83607 Holzkirchen (DE)

(56) Entgegenhaltungen:
- GB-A- 2 241 111
- GB-A- 2 261 990
- US-A- 4 901 127
- PATENT ABSTRACTS OF JAPAN vol. 014, no. 257 (E-0936), 4.Juni 1990 & JP 02 078275 A (HITACHI LTD), 19.März 1990,
- PATENT ABSTRACTS OF JAPAN vol. 009, no. 248 (E-347), 4.Oktober 1985 & JP 60 098671 A (TOSHIBA KK), 1.Juni 1985,

## Beschreibung

In M. Darwish et al, Electronics Letters, Vol. 20, No. 12, Seite 519 bis 520 (1984) ist ein sogenannter Insulated Gate Bipolar-Transistor, abgekürzt IGBT, vorgeschlagen worden. Dabei handelt es sich um einen Hochspannungs-DMOS-Transistor, bei dem der Hauptstrom einen in Durchlaßrichtung gepolten pn-Übergang durchfließt. Der pn-Übergang wird gebildet durch eine Emitterstruktur, die von einem vom entgegengesetzten Leitfähigkeitstyp schwach dotierten Driftbereich umgeben ist. Im eingeschalteten Zustand werden von diesem pn-Übergang Ladungsträger injiziert, die die Leitfähigkeit des Driftbereichs erhöhen.

Im Fall einer Spannungsumkehr am IGBT ist der aus Emitterstruktur und Driftbereich gebildete pn-Übergang in Sperrichtung gepolt. In Anwendungen, in denen im Fall der Spannungsumkehr ein hoher Strom fließt, muß dieser pn-Übergang erst in den Durchbruch getrieben werden, bevor der IGBT diesen Strom tragen kann. Hochstrombelastungen im Durchbruch des pn-Übergangs führen meist zur Zerstörung des Bauelementes.

Um in derartigen Anwendungen eine Zerstörung des Bauelementes zu vermeiden, wird, wie aus der Schrift GB-A-2 261 990 bekannt (entspricht dem Oberbegriff des Anspruchs 1), parallel zu dem IGBT eine Freilaufdiode geschaltet, über die ein bei Spannungsumkehr auftretender hoher Strom abfließen kann. Die Freilaufdiode muß für diesen hohen Strom dimensioniert werden und sie muß eine Sperrfähigkeit aufweisen, die mit der Sperrfähigkeit des IGBT vergleichbar ist, so daß sie einen hohen Platzbedarf aufweist.

Der Erfindung liegt das Problem zugrunde, eine integrierte Schaltungsanordnung mit einem IGBT anzugeben, die einen geringeren Platzbedarf als die bekannte Lösung aufweist und bei der eine Zerstörung des IGBT durch hohen Strom bei einer Spannungsumkehr vermieden wird.

Dieses Problem wird erfindungsgemäß gelöst durch eine integrierte Schaltungsanordnung gemäß Anspruch 1. Weitere Ausgestaltungen der Erfindung gehen aus den übrigen Ansprüchen hervor.

In der integrierten Schaltungsanordnung ist der IGBT mit einem zusätzlichen Nebenkontakt versehen, der den Driftbereich anschließt. Zwischen den Nebenkontakt und die Anode des IGBT ist eine Diode geschaltet, deren Anode mit dem Nebenkontakt und deren Kathode mit der Anode des IGBT verbunden ist. Im leitenden Zustand des IGBT sperrt die Diode und der Hauptstromfluß erfolgt über die Anode des IGBT. Dafür ist eine Sperrfähigkeit der Diode von einigen Volt, vorzugsweise 1 Volt bis 20 Volt, ausreichend. Bei einer Spannungsumkehr ist die Diode in Durchlaßrichtung gepolt und der Stromfluß erfolgt direkt über den Nebenkontakt und den Driftbereich. In diesem Fall wirkt der aus Driftbereich und Kanalbereich gebildete pn-Übergang als interne Freilauf des IGBT.

Da die Diode nur eine geringe Sperrfähigkeit aufweisen muß, ist der Platzbedarf für die Diode erheblich geringer als derjenige für die aus dem Stand der Technik bekannte zusätzliche Freilaufdiode. Da die Diode vergleichsweise einfach herstellbar ist, insbesondere keine speziellen Anforderungen an die Photolithographie gestellt werden, ist die erfindungsgemäße Schaltungsanordnung im Vergleich zu der aus dem Stand der Technik bekannten Schaltung aus Hochspannungs-IGBT und Hochspannungsdiode in Bezug auf den Flächenbedarf verbessert.

Im Vergleich zu einem DMOS-Transistor weist die erfindungsgemäße integrierte Schaltungsanordnung einen nur um eine Diodenschwellspannung von etwa 0,5 Volt höheren Spannungsabfall auf.

Als Diode kann sowohl eine pn-Diode als auch eine Schottky-Diode verwendet werden.

In Bezug auf die Sperrfähigkeit des IGBT ist es vorteilhaft, die integrierte Schaltungsstruktur in einer Siliziumschicht eines SOI-Substrats zu realisieren. Der IGBT ist dabei als lateraler IGBT ausgebildet. Gegenüber der Diode ist der IGBT lateral durch einen isolierenden Graben und vertikal durch eine isolierende Schicht, die im SOI-Substrat unterhalb der Siliziumschicht angeordnet ist, isoliert. Der isolierende Graben reicht dabei bis auf die Oberfläche der isolierenden Schicht. Der isolierende Graben und die isolierende Schicht bilden eine Isolationswanne für den IGBT. Vorzugsweise wird die Dotierstoffkonzentration in der Isolationswanne so eingestellt, daß im sperrenden Zustand des IGBT ein Teil des elektrischen Feldes in die isolierende Schicht gedrängt wird.

Im folgenden wird die Erfindung anhand eines Ausführungsbeispiels und der Figuren näher erläutert.
- Figur 1: zeigt eine Aufsicht auf eine integrierte Schaltungsanordnung mit einem IGBT und einer Niederspannungsdiode.
- Figur 2: zeigt den in Figur 1 mit II-II bezeichneten Schnitt durch den IGBT.
- Figur 3: zeigt den in Figur 1 mit III-III bezeichneten Schnitt durch die Niederspannungsdiode.

Die Schnittzeichnungen sind nicht maßstäblich.

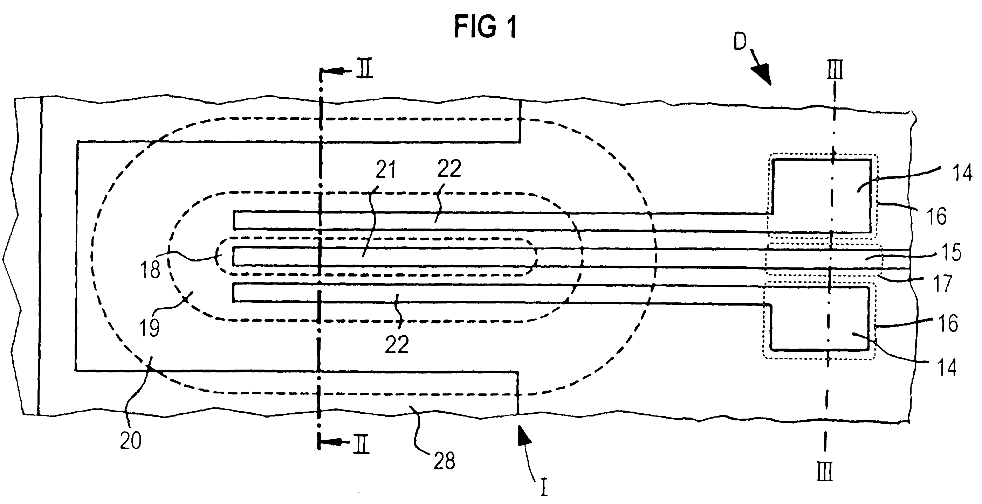

In Figur 1 ist eine Aufsicht auf eine erfindungsgemäße integrierte Schaltungsanordnung mit einem IGBT I und einer Diode D dargestellt. Durch gestrichelte Linien sind die Lage einer p⁺-dotierten Emitterstruktur 18, eines n⁺-dotierten Anschlußgebietes 19 sowie eines n⁻-dotierten Driftbereichs 20 angegeben. Die Emitterstruktur 18 weist eine Dotierstoffkonzentration von zum Beispiel 10¹⁹ cm⁻³, das Anschlußgebiet 19 von zum Beispiel 10¹⁹ cm⁻³ und der Driftbereich 20 von zum Beispiel 6 x 10¹⁴ cm⁻³ auf.

Die Emitterstruktur 18 ist mit einer Anode 21 verbunden, die oberhalb der Emitterstruktur 18 verläuft. Das n⁺-dotierte Anschlußgebiet 19, das die Emitterstruktur 18 an der Oberfläche ringförmig umgibt, ist mit zwei Nebenkontakten 22 versehen. Die Nebenkontakte 22 verlaufen parallel zur Anode 21 oberhalb des n⁺-dotierten Anschlußgebietes 19.

Durch gestrichelte Linien sind ferner die Lage zweier p⁺-dotierter Gebiete 16 sowie eines n⁺-dotierten Gebietes 17 der Diode D angegeben. Die p⁺-dotierten Gebiete 16 weisen eine Dotierstoffkonzentration von zum Beispiel 10¹⁹ cm⁻³, das n⁺-dotierte Gebiet 17 von 10¹⁹ cm⁻³ auf.

Oberhalb der p⁺-dotierten Gebiete 16 ist jeweils ein erster Kontakt 14 angeordnet, der mit dem jeweiligen p⁺-dotierten Gebiet 16 verbunden ist. Ferner sind die ersten Kontakte 14 mit jeweils einem der Nebenkontakte 22 elektrisch verbunden. Oberhalb des n⁺-dotierten Gebietes 17 ist ein zweiter Kontakt 15 angeordnet, der mit dem n⁺-dotierten Gebiet 17 verbunden ist. Der zweite Kontakt 15 ist ferner mit der Anode 21 verbunden.

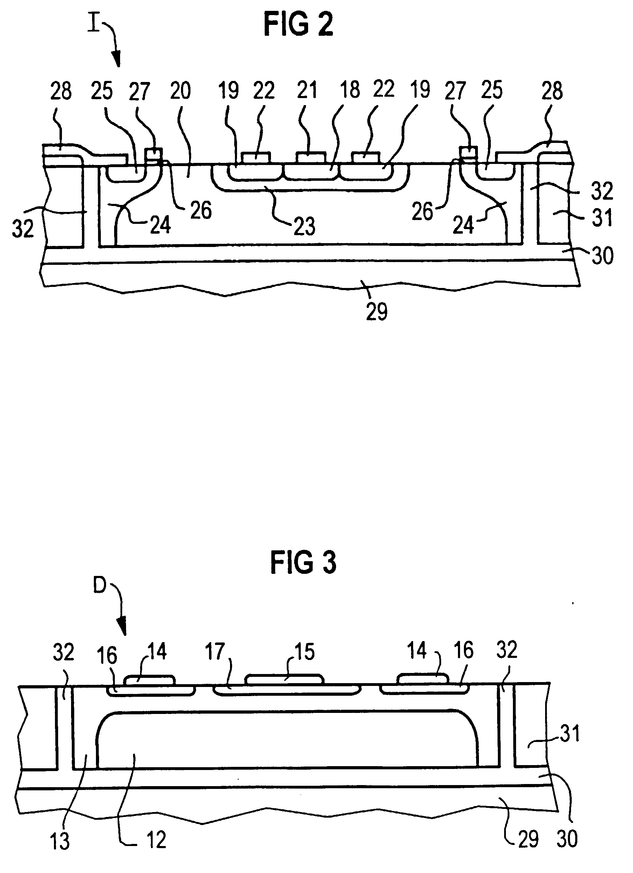

In Figur 2 ist der in Figur 1 mit II-II bezeichnete Schnitt durch den IGBT I dargestellt. Die Emitterstruktur 18 und das Anschlußgebiet 19 sind in einer n-dotierten Insel 23 angeordnet, die im Driftbereich 20 angeordnet ist. Der Driftbereich 20 grenzt an ein p-dotiertes Gebiet 24 an, das einen Kanalbereich des IGBT umfaßt. Das p-dotierte Gebiet 24 weist eine Dotierstoffkonzentration von zum Beispiel 2 x 10¹⁷ cm⁻³ auf. In dem p-dotierten Gebiet 24 ist ein n⁺-dotiertes, ringförmiges Sourcegebiet 25 angeordnet. An der Oberfläche des Kanalbereichs ist ein Gatedielektrikum 26 und darauf eine Gateelektrode 27 angeordnet. Die Gateelektrode 27 ist der Übersichtlichkeit halber in der Aufsicht in Figur 1 nicht eingezeichnet. Auf der dem Kanalbereich abgewandten Seite des Sourcegebietes 25 sind das Sourcegebiet 25 und das p-dotierte Gebiet 24 über eine an der Oberfläche angeordnete Kathode 28 miteinander verbunden.

Der IGBT I ist in einem SOI-Substrat realisiert, das eine einkristalline Siliziumscheibe 29, eine darauf angeordnete isolierende Schicht 30 und eine darauf angeordnete einkristalline Siliziumschicht 31 umfaßt. In der Siliziumschicht 31 ist der IGBT I realisiert. Er ist vollständig von einem Isolationsgraben 32 umgeben, der bis auf die Oberfläche der isolierenden Schicht 30 reicht und der mit isolierendem Material gefüllt ist.

Außerhalb des Isolationsgrabens 32 ist in der Siliziumschicht 31 die Diode D realisiert (siehe Figur 1 und den in Figur 1 mit III-III bezeichneten Schnitt, der in Figur 3 dargestellt ist). Die Diode D ist ebenfalls von einem Isolationsgraben 32 vollständig umgeben, der mit isolierendem Material gefüllt ist und der bis auf die Oberfläche der isolierenden Schicht 30 reicht. Die p⁺-dotierten Gebiete 16 sowie das n⁺-dotierte Gebiet 17 sind in einer p-dotierten Wanne angeordnet. An den Wänden des isolierenden Grabens 32 reicht die p-dotierte Wanne 13, die eine Dotierstoffkonzentration von zum Beispiel 5 x 10¹⁷ cm⁻³ aufweist bis auf die Oberfläche der isolierenden Schicht 30. Die p-dotierte Wanne 13 weist eine Tiefe von zum Beispiel 3 µm auf. Unter der p-dotierten Wanne 13 ist ein n⁻-dotiertes Gebiet 12 angeordnet, das eine Dotierstoffkonzentration von zum Beispiel 6 x 10¹⁴ cm⁻³ aufweist.

Im eingeschalteten Zustand des IGBT I fließt der Hauptstrom über die Anode 21. Die Diode D ist in diesem Fall in Sperrrichtung gepolt. Kommt es beim Abschalten des IGBT I zu einer Spannungsumkehr, so ist die Diode D in Durchlaßrichtung gepolt. Der Hauptstrom fließt dann über die Diode D, den Nebenkontakt 22 und den aus Driftbereich 20 und p-dotiertes Gebiet 24 gebildeten, in Durchlaßrichtung gepolten pn-Übergang, der eine interne Freilaufdiode bildet. Einen Durchbruch des in diesem Fall in Sperrichtung gepolten pn-Übergangs, der aus Emitterstruktur 18 und n-dotierter Insel 23 gebildet wird, wird auf diese Weise vermieden.

Durch Aufduplizieren der Fingerstruktur der Emitterstruktur 18 und entsprechendes Aufduplizieren der n⁺-dotierten Gebiete 17 und p⁺-dotierten Gebiete 16 der Diode D läßt sich die Erfindung auf großflächige Bauelemente übertragen.

## Patentansprüche

1. Integrierte Schaltungsanordnung
- mit mindestens einem IGBT (I) mit einem Driftbereich (20), einem Kanalbereich (24), einem Gatedielektrikum (26), einer Gateelektrode (27), einem Sourcegebiet (25), einer Emitterstruktur (18), einer mit Sourcegebiet (25) und Kanalbereich (24) verbundenen Kathode (28), einer mit der Emitterstruktur (18) verbundenen Anode (21)
und mit einer Diode (D) mit einer Anode (14) und einer Kathode (15), dadurch gekennzeichnet, daß der Driftbereich (20) mit einem von der Anode des IGBT getrennten Nebenkontakt (22) versehen ist und
- die Diode so zwischen den Nebenkontakt (22) und die Anode (21) des IGBT (I) verschaltet ist, daß die Kathode (15) der Diode (D) mit der Anode (21) des IGBT (I) und die Anode (14) der Diode (D) mit dem Nebenkontakt (22) des IGBT (I) verbunden ist.

2. Schaltungsanordnung nach Anspruch 1,
- bei der der IGBT (I) und die Diode (D) in einer Siliziumschicht (31) eines SOI-Substrats (31, 30, 29) integriert sind, wobei der IGBT (I) als lateraler IGBT ausgebildet ist,
- bei der in der Siliziumschicht (31) mindestens ein isolierender Graben (32) vorgesehen ist, der den IGBT (I) vollständig umgibt und der bis auf die Oberfläche einer im SOI-Substrat unter der Siliziumschicht (31) angeordneten isolierenden Schicht (30) reicht,
- bei der die Dotierstoffkonzentration innerhalb des Isolationsgrabens (32) so eingestellt ist, daß im sperrenden Zustand des IGBT ein Teil des elektrischen Feldes in die isolierende Schicht (30) gedrängt wird.

3. Schaltungsanordnung nach Anspruch 1 oder 2,
bei der der Driftbereich (20) einen Anschlußbereich (19) erhöhter Dotierstoffkonzentration gleichen Leitfähigkeitstyps umfaßt, auf dem der Nebenkontakt (22) angeordnet ist.

4. Schaltungsanordnung nach einem der Ansprüche 1 bis 3,
bei der die Diode (D) als pn-Diode oder als Schottky-Diode ausgebildet ist.

## Claims

1. Integrated circuit arrangement
- with at least one IGBT (I) having a drift region (20), a channel region (24), a gate dielectric (26), a gate electrode (27), a source region (25), an emitter structure (18), a cathode (28), which is connected to the source region (25) and the channel region (24), an anode (21), which is connected to the emitter structure (18),
- and with a diode (D) having an anode (14) and a cathode (15),
characterized in that the drift region (20) is provided with an auxiliary contact (22), which is separated from the anode of the IGBT, and the diode is connected up between the auxiliary contact (22) and the anode (21) of the IGBT (I) in such a way that the cathode (15) of the diode (D) is connected to the anode (27) of the IGBT (I) and the anode (14) of the diode (D) is connected to the auxiliary contact (22) of the IGBT (I).

2. Circuit arrangement according to Claim 1,
- in which the IGBT (I) and the diode (D) are integrated in a silicon layer (31) of an SOI substrate (31, 30, 29), the IGBT (I) being designed as a lateral IGBT,
- in which at least one insulating trench (32) is provided in the silicon layer (31), which trench completely surrounds the IGBT (I) and reaches down to the surface of an insulating layer (30) arranged below the silicon layer (31) in the SOI substrate,
- in which the dopant concentration within the insulation trench (32) is set in such a way that in the off state of the IGBT, part of the electric field is displaced into the insulating layer (30).

3. Circuit arrangement according to Claim 1 or 2,
in which the drift region (20) comprises a terminal region (19) of increased dopant concentration of the same conductivity type, on which the auxiliary contact (22) is arranged.

4. Circuit arrangement according to one of Claims 1 to 3,
in which the diode (D) is designed as a pn diode or as a Schottky diode.

## Revendications

1. Dispositif de circuit intégré
- comprenant au moins un IGBT (I) avec une zone de dérive (20), une zone de voie (24), un diélectrique de grille (26), une électrode de grille (27), une zone source (25), et une structure émettrice (18), une cathode (28) reliée à une zone source (25) et à une zone de voie (24), une anode (21) reliée à la structure émettrice (18) et à une diode (D) avec une anode (14) et une cathode (15), caractérisé en ce que la zone de dérive (20) est pourvue d'un contact secondaire (22) séparé de l'anode de l'IGBT, et la diode est connectée entre le contact secondaire (22) et l'anode (21) de l'IGBT (I) de telle sorte que la cathode (15) de la diode (D) est connectée à l'anode (21) de l'IGBT (I) et l'anode (14) de la diode (D) au contact secondaire (22) de l'IGBT (I).

2. Dispositif de circuit selon la revendication 1,
- dans lequel l'IGBT (I) et la diode (D) sont intégrés dans une couche de silicium (31) d'un substrat SOI (31, 30, 29), l'IGBT (I) étant formé en tant qu'lGBT latéral,
- dans lequel est prévue dans la couche de silicium (31) au moins une tranche isolante (32), qui entoure complètement l'IGBT (I) et qui s'étend jusqu'à la surface d'une couche isolante (30) disposée dans le substrat SOI sous la couche de silicium (31),
- dans lequel la concentration d'agent dopant à l'intérieur de la tranche isolante (32) est ajustée de telle sorte qu'à l'état bloquant de l'IGBT une partie du champ électrique soit poussée dans la couche isolante (30).

3. Dispositif de circuit selon la revendication 1 ou 2, dans lequel la zone de dérive (20) comprend une zone de raccordement (19) d'une concentration d'agent dopant supérieure de même type de conductibilité, sur laquelle le contact secondaire (22) est disposé.

4. Dispositif de circuit selon l'une des revendications 1 à 3, dans lequel la diode (D) est formée comme diode pn ou comme diode Schottky.
